# FASCICULE DE BREVET EUROPEEN

(11) **EP 0 903 783 B1**
(45) Date de publication et mention de la délivrance du brevet: **17.08.2005**
(21) Numéro de dépôt: 98410105.5
(22) Date de dépôt: 18.09.1998
(51) Int. Cl.: H01L 23/522

(54) **Réalisation d'un condensateur intermétallique**
Realisierung eines intermetallischen Kondensators
Realization of an intermetallic capacitor

(30) Priorité: 22.09.1997 FR 9711966
(43) Date de publication de la demande: 24.03.1999
(73) Titulaire: STMicroelectronics S.A., 92120 Montrouge (FR)
(72) Inventeur: Bonhoure, Bruno, 38000 Grenoble (FR); Tournier, Véronique, 38170 Seyssinet-Pariset (FR)
(74) Mandataire: de Beaumont, Michel

(56) Documents cités:
- EP-A- 0 353 414
- PATENT ABSTRACTS OF JAPAN vol. 006, no. 147 (E-123), 6 août 1982 -& JP 57 071165 A (TOSHIBA CORP), 1 mai 1982
- PATENT ABSTRACTS OF JAPAN vol. 095, no. 006, 31 juillet 1995 -& JP 07 058294 A (KAWASAKI STEEL CORP), 3 mars 1995
- PATENT ABSTRACTS OF JAPAN vol. 095, no. 008, 29 septembre 1995 -& JP 07 130953 A (NIPPON TELEGR & TELEPH CORP), 19 mai 1995
- PATENT ABSTRACTS OF JAPAN vol. 013, no. 364 (E-805), 14 août 1989 -& JP 01 120858 A (MITSUBISHI ELECTRIC CORP), 12 mai 1989

## Description

La présente invention concerne la réalisation d'un condensateur dans un circuit intégré multicouches. La présente invention s'applique plus particulièrement aux circuits intégrés mixtes comprenant une partie numérique et une partie analogique.

Dans un circuit intégré mixte en technologie CMOS, les transistors MOS sont généralement répartis dans des blocs distincts selon qu'ils appartiennent aux parties analogique ou numérique du circuit. Les blocs analogique et numérique sont généralement alimentés séparément l'un de l'autre, c'est-à-dire au moyen de broches différentes du circuit intégré.

Dans une technologie HCMOS à plusieurs couches métalliques, un condensateur est généralement réalisé entre le niveau de métallisation inférieur et le niveau immédiatement supérieur. Pour réduire l'encombrement en surface du condensateur, on réalise usuellement un condensateur par l'assemblage de deux capacités symétriques de part et d'autre d'une portion de couche métallique inférieure.

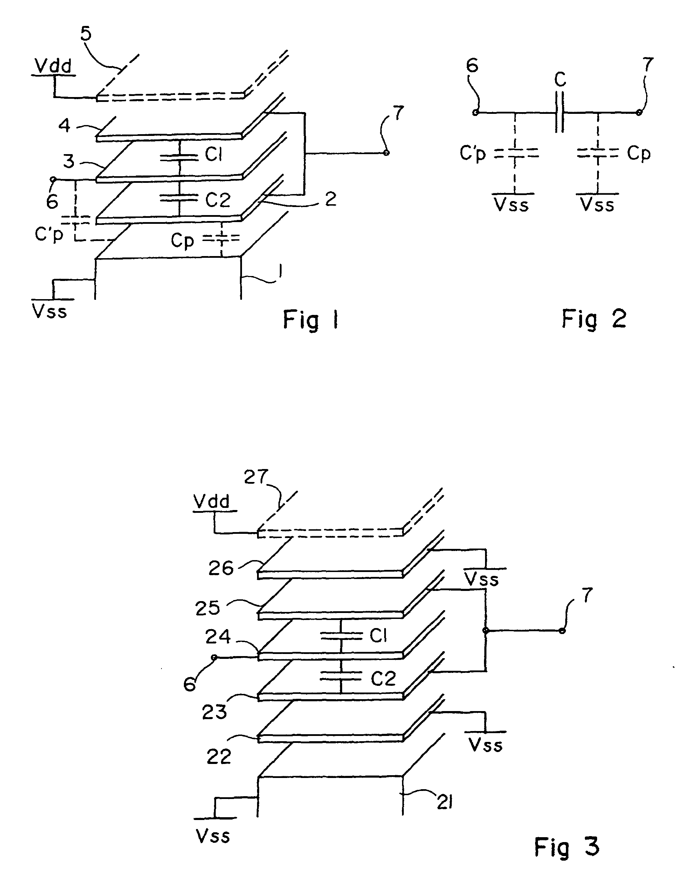

La figure 1 représente, de façon très schématique, un exemple de réalisation classique d'un condensateur en technologie HCMOS à plusieurs couches métalliques. Au-dessus d'un substrat 1 de type P, dans lequel sont formés les transistors MOS, il est prévu le dépôt et la gravure successifs d'une couche 2 de silicium polycristallin, et de plusieurs couches métalliques 3, 4. Une deuxième couche de silicium polycristallin est éventuellement prévue. Chaque couche est séparée des deux couches voisines par une couche diélectrique, généralement en oxyde de silicium.

Au sens de la présente invention, on appelle "niveau de métallisation", indifféremment une couche de silicium polycristallin ou une couche métallique.

A la figure 1, le condensateur est formé de deux capacités intermétalliques C1, C2, respectivement entre les couches 3, 4 et 2, 3. Une première borne 6 du condensateur est constituée par un plot de contact à la couche intermédiaire 3. Une deuxième borne 7 du condensateur est constituée par un plot de contact relié aux couches 2 et 4, de sorte que les capacités C1 et C2 sont en parallèle. D'autres niveaux sont généralement prévus au-dessus du niveau 4, par exemple, au moins une couche métallique 5 qui sert à former les pistes de raccordement des différents composants à un potentiel positif d'alimentation Vdd. Le substrat 1 est à un potentiel Vss, généralement la masse.

Des capacités parasites Cp, C'p sont respectivement présentes entre la couche 2 et le substrat 1, et entre la piste de liaison de la borne 6 à la couche 3 et le substrat 1. De même, si le motif de gravure de la couche 5 (ou de tout autre niveau de métallisation supérieur) conduit à ce que cette couche soit présente à l'aplomb du condensateur réalisé, des capacités parasites (non représentées) apparaissent entre la couche 4 et la couche 5, et entre la liaison de la borne 6 à la couche 3 et la couche 5.

La figure 2 représente le schéma électrique équivalent du condensateur C ainsi réalisé entre les bornes 6 et 7. Pour des raisons de clarté, on a tenu compte uniquement des capacités parasites Cp, C'p, côté substrat 1.

Un problème qui se pose lors du fonctionnement du circuit est que la charge du condensateur C est susceptible d'être polluée par des bruits traversant les capacités Cp, C'p. Ce problème est particulièrement critique dans les circuits mixtes en raison des bruits de commutation de la partie numérique du circuit qui polluent la masse et transitent par le substrat 1 jusqu'à l'aplomb du condensateur.

L'importance de ce problème dépend du rapport signal/bruit souhaité pour le condensateur, donc de l'importance du niveau de charge de ce condensateur. Plus le niveau de charge que doit mémoriser le condensateur est faible, plus l'influence des bruits de commutation est grande.

Un exemple d'application auquel se rapporte la présente invention est celui des convertisseurs analogiques-numériques utilisant des comparateurs dits "auto-zéro" qui requièrent un condensateur de mémorisation lors de l'échantillonnage.

Dans un tel convertisseur, l'élément quantifiable le plus petit est fonction de la valeur de la tension de référence et du nombre de bits du convertisseur. Par exemple, pour une tension de référence de l'ordre de 1,5 volts, l'élément quantifiable le plus petit est, dans le cas d'un convertisseur 8 bits, de l'ordre de 6 à 7 millivolts. Or, le bruit ramené par les capacités parasites est sensiblement indépendant de la tension d'alimentation, donc de la tension de référence. Par conséquent, une diminution de la valeur de l'élément quantifiable le plus petit altère le rapport signal/bruit, tandis que la miniaturisation des circuits intégrés conduit à diminuer les tensions d'alimentation, afin de réduire la puissance consommée.

On notera que le même problème se pose pour tout condensateur intermétallique de mémorisation dont le niveau de charge n'est pas négligeable devant les bruits de commutation.

La présente invention vise à rendre les condensateurs intermétalliques de mémorisation indépendants de bruits de commutation susceptibles de polluer les alimentations du circuit intégré.

Plus particulièrement, la présente invention vise à proposer un nouveau procédé de réalisation d'un condensateur intermétallique dans un circuit intégré multicouches.

Une caractéristique de la présente invention est de laisser subsister, de part et d'autre de niveaux de métallisation extrêmes d'un condensateur intermétallique, et avant les niveaux de métallisation extrêmes du circuit, deux portions de couches polarisables. Ainsi, selon la présente invention, au moins une portion d'une couche polarisable est présente entre le substrat et une portion d'un premier niveau de métallisation extrême du condensateur. A l'autre extrémité de l'empilement, au moins une portion d'une couche polarisable est présente entre la portion du deuxième niveau de métallisation extrême du condensateur et une couche métallique dans lequel sont généralement formées les pistes d'alimentation du circuit.

Une autre caractéristique de la présente invention est que ces deux portions de couches polarisables sont reliées à la masse du circuit intégré. Par conséquent, la présente invention intercale, dans l'épaisseur du circuit, deux régions froides de part et d'autre du condensateur intermétallique.

Plus particulièrement, la présente invention prévoit un procédé de réalisation d'un condensateur intermétallique dans un circuit intégré multicouches comprenant, à partir d'un substrat de type P, au moins cinq niveaux de métallisation, ce procédé consistant :
à laisser subsister, de part et d'autre de portions de niveaux de métallisation extrêmes du condensateur, au moins une portion d'un niveau polarisable distinct du substrat et du dernier niveau de métallisation ; et
à polariser, au moins à l'aplomb du condensateur et au potentiel du substrat, les deux portions polarisables.

Selon un mode de réalisation de la présente invention, le condensateur est formé entre trois niveaux de métallisation, une première borne du condensateur étant formée par un contact au niveau intermédiaire, et une deuxième borne étant formée par un contact commun aux niveaux extrêmes du condensateur.

La présente invention prévoit également un condensateur intermétallique réalisé dans un circuit intégré multicouches comprenant, à partir d'un substrat de type P, au moins cinq niveaux de métallisation, les deux niveaux définissant des portions extrêmes du condensateur étant séparés, respectivement du substrat et d'un dernier niveau de métallisation, par une portion d'un niveau polarisable.

Selon un mode de réalisation de la présente invention, chaque portion polarisable est connectée au potentiel substrat.

Selon un mode de réalisation de la présente invention, appliqué à la réalisation d'un condensateur intermétallique dans un circuit intégré mixte, les portions polarisables sont connectées directement à la masse analogique du circuit intégré.

Selon un mode de réalisation de la présente invention, le condensateur est réalisé, dans un circuit en technologie HCMOS comprenant une couche de silicium polycristallin et cinq couches de métal, entre les première, deuxième et troisième couches de métal.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 qui ont été décrites précédemment sont destinées à exposer l'état de la technique et le problème posé ; et
la figure 3 représente, de façon très schématique, un mode de réalisation d'un condensateur intermétallique selon la présente invention.

Pour des raisons de clarté, seuls les éléments nécessaires à la compréhension de l'invention ont été représentés aux figures et seront décrits par la suite.

La figure 3 représente un mode de réalisation d'un condensateur intermétallique selon la présente invention.

Le mode de réalisation représenté à la figure 3 est réalisé dans une technologie comprenant six niveaux de métallisation, c'est-à-dire à partir d'un substrat 21, une couche de silicium polycristallin 22 et cinq couches de métal 23, 24, 25, 26 et 27. Dans une telle technologie, un condensateur intermétallique selon l'invention est formé entre les première, deuxième et troisième couches de métal 23, 24 et 25. Comme précédemment, pour minimiser l'encombrement en surface du condensateur, des capacités C1 et C2 sont associées en parallèle, une première borne 6 du condensateur étant définie par un contact à la couche 24, et une deuxième borne 7 du condensateur étant définie par un contact commun aux couches 23 et 25.

La couche métallique supérieure 27 est, par exemple, la couche dans laquelle sont réalisées les pistes d'alimentation positive des composants du circuit intégré.

Selon la présente invention, la portion du niveau de métallisation (ici, la couche de silicium polycristallin 22), présente entre le substrat 21 et la couche 23 à l'aplomb du condensateur intermétallique, est polarisée au potentiel Vss, c'est-à-dire la masse. De même, la quatrième couche métallique 26 est, au moins dans sa portion à l'aplomb du condensateur, polarisée au potentiel Vss.

La connexion de la couche de silicium polycristallin 22 à la masse a pour effet d'empêcher la propagation des bruits de commutation transitant par le substrat 21 jusqu'au condensateur.

La connexion de la quatrième couche de métal 26 à la masse a pour effet de protéger le condensateur de la couche 27 polarisée à Vdd, donc des pics de commutation positifs.

De préférence, les polarisations des couches 22 et 26 sont effectuées par la masse de la partie analogique du circuit intégré qui se trouve nettement moins polluée par les bruits de commutation que la masse de la partie numérique.

Un avantage de la présente invention est que l'on enferme le condensateur intermétallique entre deux niveaux, distincts du substrat et de la couche supérieure de métallisation dans lesquels sont réalisées les alimentations. En polarisant ces deux niveaux à la masse, le condensateur se trouve enfermé entre deux régions froides, ce qui l'isole des capacités parasites entre le substrat 21 et le premier niveau de métallisation et entre les dernier 27 et avant-dernier 26 niveaux de métallisation.

En effet, la couche 22 étant directement connectée à la masse par un plot, les charges sont évacuées et il n'y a pas de couplage entre la couche 22 et la couche 23. De plus, on supprime la capacité parasite (C'p, figure 1) entre la liaison de la couche 24 à la borne 6 et le substrat 21.

Côté alimentation positive, la connexion directe à la masse de la couche 26 au moyen d'un plot conduit à ce que cette connexion présente une impédance nettement plus faible que la connexion indirecte par l'intermédiaire de la capacité parasite entre les couches 26 et 27. Ainsi, bien que les capacités parasites soient du même ordre de grandeur, la masse apportée par la couche 26 n'est pas bruitée. A titre d'exemple particulier, l'ordre de grandeur d'une capacité intermétallique parasite est de l'ordre de 20 à 100 femptofarad, et l'impédance des lignes de connexion à la masse est de l'ordre de quelques ohms. Par conséquent, pour une fréquence de travail d'un convertisseur analogique-numérique qui est généralement de l'ordre de quelques dizaines de MHz, l'impédance des lignes de connexion à la masse est parfaitement négligeable devant celle de la capacité parasite.

On notera que la présente invention s'applique également à la réalisation d'un condensateur intermétallique dans une technologie comprenant une couche de silicium polycristallin et quatre couches de métal. Dans ce cas, le condensateur est toutefois réalisé uniquement entre deux niveaux de métallisation de manière à encadrer ce condensateur par deux niveaux connectés à la masse, distincts du substrat et de la dernière couche métallique recevant l'alimentation positive. De même, l'invention s'applique à un circuit comprenant plus de cinq couches de métal.

Bien entendu, la présente invention est susceptible de diverses variantes et modifications qui apparaîtront à l'homme de l'art. En particulier, bien que l'on ait fait référence dans la description qui précède à des condensateurs appliqués à des convertisseurs analogiques-numériques, l'invention trouve un intérêt dans toute application pour laquelle un condensateur est utilisé pour un transfert de charge et dans laquelle on souhaite améliorer le rapport signal/bruit.

## Revendications

1. Procédé de réalisation d'un condensateur intermétallique (C) dans un circuit intégré multicouches comprenant, à partir d'un substrat de type P (21), au moins cinq niveaux de métallisation, **caractérisé en ce qu'**il consiste :
à laisser subsister, de part et d'autre de portions de niveaux de métallisation extrêmes du condensateur, au moins une portion d'un niveau polarisable (22, 26) distinct du substrat et du dernier niveau de métallisation (27) ; et
à polariser, au moins à l'aplomb du condensateur et au potentiel du substrat (21), les deux portions polarisables.

2. Procédé selon la revendication 1, **caractérisé en ce que** le condensateur (C1, C2) est formé entre trois niveaux de métallisation (23, 24, 25), une première borne (6) du condensateur étant formée par un contact au niveau intermédiaire (24), et une deuxième borne (7) étant formée par un contact commun aux niveaux extrêmes (23, 25) du condensateur.

3. Condensateur intermétallique réalisé dans un circuit intégré multicouches comprenant, à partir d'un substrat (21) de type P, au moins cinq niveaux de métallisation, **caractérisé en ce que** les deux niveaux (23, 25) définissant des portions extrêmes du condensateur sont séparés, respectivement du substrat (21) et d'un dernier niveau (27) de métallisation, par une portion d'un niveau (22, 26) polarisable.

4. Condensateur selon la revendication 3, **caractérisé en ce que** chaque portion polarisable (22, 26) est connectée au potentiel substrat.

5. Condensateur selon la revendication 3 ou 4, réalisé dans un circuit intégré mixte, **caractérisé en ce que** les portions (22, 26) polarisables sont connectées directement à la masse analogique du circuit intégré.

6. Condensateur selon l'une quelconque des revendications 3 à 5, **caractérisé en ce qu'**il est réalisé, dans un circuit en technologie HCMOS comprenant une couche de silicium polycristallin (22) et cinq couches de métal, entre les première, deuxième et troisième couches (23, 24, 25) de métal.

## Claims

1. A method of implementation of a an intermetallic capacitor (C) in a multiple layer integrated circuit including, from a P-type substrate (21), at least five levels of metallization, **characterized in that** it consists of:
letting remain, on either side of portions of end metallization levels of the capacitor, at least one portion of a biasable level (22, 26) distinct from the substrate and from the last metallization level (27); and
biasing, at least above the capacitor and to the potential of the substrate (21), the two biasable portions.

2. The method of claim 1, wherein the capacitor (C1, C2) is formed of three metallization levels (23, 24, 25), a first terminal (6) of the capacitor being formed by a contact to the intermediary level (24), and a second terminal (7) being formed by a contact common to the end levels (23, 25) of the capacitor.

3. A multilayer integrated circuit with an intermetallic capacitor including, on a P-type substrate (21), at least five metallization levels, **characterized in that** the two levels (23, 25) defining end portions of the capacitor are separated, respectively, from the substrate (21) and from a last metallization level (27), by a portion of a biasable level (22, 26).

4. The circuit of claim 3, wherein each biasable portion (22, 26) is connected to the substrate potential.

5. The circuit of claim 3 or 4, implemented in a compound integrated circuit, wherein the biasable portions (22, 26) are connected directly to the analog ground of the integrated circuit.

6. The circuit of any of claims 3 to 5, implemented, in a circuit in HCMOS technology including one polysilicon layer (22) and five metal layers, between the first, second, and third metal layers (23, 24, 25).

## Patentansprüche

1. Verfahren zum Implementieren eines Zwischenmetallkondensators (C) in einer mehrlagigen integrierten Schaltung, die ausgehend von einem P-Typ-Substrat (21) wenigstens fünf Metallisierungsebenen besitzt, **gekennzeichnet durch** die folgenden Schritte:
Verbleibenlassen auf jeder Seite von Teilen von Endmetallisierungsebenen des Kondensators wenigstens einen Teil einer vorspannbaren Ebene (22, 26) getrennt von dem Substrat und von der letzten Metallisierungsebene (27); und Vorspannen der zwei vorspannbaren Teile wenigstens über den Kondensator und auf das Potential des Substrats (21).

2. Verfahren nach Anspruch 1, wobei der Kondensator (C1, C2) aus drei Metallisierungsebenen (23, 24, 25) gebildet ist, wobei ein erster Anschluss (6) des Kondensators durch einen Kontakt mit der Zwischenebene (24) und ein zweiter Anschluss (7) durch einen Kontakt gebildet wird, der den Endebenen (23, 25) des Kondensators gemeinsam ist.

3. Mehrlagige integrierte Schaltung mit einem Zwischenmetallkondensator, der auf einem P-Typ-Substrat (21) wenigstens fünf Metallisierungsebenen besitzt, **dadurch gekennzeichnet, dass** die zwei Ebenen (23, 25), welche Endteile des Kondensators definieren, jeweils von dem Substrat (21) und von einer letzten Metallisierungsebene (27) getrennt sind durch einen Teil einer vorspannbaren Ebene (22, 26).

4. Schaltung nach Anspruch 3, wobei jeder vorspannbare Teil (22, 26) mit dem Substratpotential verbunden ist.

5. Schaltung nach Anspruch 3 oder 4 implementiert in einer integrierter Verbundschaltung, wobei die vorspannbaren Teile (22, 26) direkt mit der Analogmasse der integrierten Schaltung verbunden sind.

6. Schaltung nach einem der Anspruche 3 bis 5 implementiert in einer Schaltung in HCMOS-Technologie einschließlich einer Polysiliziumlage (22) und fünf Metalllagen zwischen den ersten, zweiten und dritten Metalllagen (23, 24, 25).
